# EUROPÄISCHE PATENTSCHRIFT

(11) **EP 0 893 816 B1**
(45) Veröffentlichungstag und Bekanntmachung des Hinweises auf die Patenterteilung: **21.10.2009**
(21) Anmeldenummer: 98111715.3
(22) Anmeldetag: 25.06.1998
(51) Int. Cl.: H01J 37/04, H01J 37/28

(54) **Korpuskularstrahlgerät**
Corpuscular beam apparatus
Appareil à faisceau corpusculaire

(30) Priorität: 25.07.1997 DE 19732093
(43) Veröffentlichungstag der Anmeldung: 27.01.1999
(73) Patentinhaber: Carl Zeiss NTS GmbH, 73447 Oberkochen (DE)
(72) Erfinder: Weimer, Eugen, Dr., 73457 Essingen (DE)
(74) Vertreter: Gnatzig, Klaus

(56) Entgegenhaltungen:
- EP-A- 0 769 799
- US-A- 5 146 090
- US-A- 5 424 541

## Beschreibung

Die Erfindung betrifft ein Korpuskularstrahlgerät, bei dem ein Objekt mit einem fokussierten Strahl elektrisch geladener Teilchen, wie Elektronen, Positronen oder Ionen bestrahlt wird, und wobei die Teilchenenergie auf Werte unter 1 keV einstellbar ist. Derartige Geräte werden in Form von Rasterelektronenmikroskopen insbesondere zur Inspektion von Halbleiterwafern sowie zur Abbildung und Analyse von Objekten mit geringer Leitfähigkeit eingesetzt. Zur Vermeidung einer Aufladung der Probenoberfläche oder zur Analyse oberflächennaher Bereiche darf die Energie beim Auftreffen auf dem Objekt bestimmte Grenzenergien nicht überschreiten, die zwischen 10 eV und 5 keV liegen.

Da die chromatischen Abbildungsfehler der zur Fokussierung des Teilchenstrahls eingesetzten elektrostatischen oder magnetischen Linsen umgekehrt proportional zur Teilchenenergie sind, ist die durch den Fokusdurchmesser des Teilchenstrahls definierte Auflösung bei niedrigen Teilchenenergien wesentlich schlechter als bei höheren Teilchenenergien. Zur Lösung dieses Problems ist es bereits bekannt, die Teilchen zunächst auf eine wesentlich höhere Energie als die beim Auftreffen auf dem Objekt gewünschte Zielenergie zu beschleunigen und die Teilchenenergie kurz vor dem Auftreffen auf dem Objekt durch eine Verzögerungseinrichtung zu reduzieren. Eine solche Verzögerungseinrichtung besteht üblicherweise aus zwei oder mehreren Elektroden, an denen ein elektrostatisches Verzögerungsfeld angelegt ist. Die Abbremsung der Teilchen kann dabei entweder im hinteren Teil des Objektivs oder nach Austritt aus dem Objektiv zwischen dem Objektiv und dem Objekt erfolgen.

Derartige bisher bekannte Lösungen lassen sich in zwei Gruppen einteilen:

Bei der ersten Gruppe von Geräten liegt das Strahlführungsrohr von der Anode bis mindestens zum Polschuhspalt des Objektivs auf Massepotential und das Objekt auf einem Hochspannungspotential, welches dasselbe Vorzeichen wie das Kathodenpotential aufweist. Derartige Anordnungen sind in dem Aufsatz von K. J. Polasko et al. "Low energy electron beam lithography" in OPTICAL ENGINEERING, März/April 1983, Seiten 195 ff, in US-A 5,389,787 und in EP-A2 0 769 799 beschrieben. Bei geringen Zielenergien, insbesondere bei Zielenergien unter 1 keV und einer Energie der Teilchen innerhalb des Strahlführungsrohres von 10-20 keV muß hier die Probe auf ein entsprechend hohes Potential von 9-19 kV gelegt werden. Neben den dabei auftretenden Isolationsproblemen am Probentisch kann es hier sehr leicht zu Spannungsüberschlägen zwischen dem Objekt und dem Objektiv oder zu Schädigungen des Objektes durch beim Ein- und Ausschalten der Hochspannung auftretende innere Ströme kommen. Auch ist ein Nachweis der vom Objekt emittierten Sekundärelektronen sehr schwierig, da diese ohne Beeinflussung des Primärstrahles abgesaugt und nachbeschleunigt werden müssen.

Bei der zweiten Variante liegt das Objekt und die objektseitige Elektrode der Verzögerungseinrichtung auf Massepotential und das Strahlführungsrohr von der Anode bis zur ersten Elektrode der Abbremseinrichtung auf einem hohen Anodenpotential, dessen Vorzeichen so gewählt ist, daß beim Austritt aus dem Strahlführungsrohr eine Verzögerung der Teilchen auftritt. Derartige Systeme sind beispielsweise in der DE 29 22 325 C2 und der EP 0 180 723 B1 beschrieben. Bei der Anordnung nach der DE 29 22 325 C2 erfolgt dabei die Einstellung der Zielenergie durch eine Variation des Potentials des Strahlführungsrohres. Diesem variablen Anodenpotential wird ein festes aber entgegengesetztes Potential zwischen der Kathode und der Anode überlagert. Bei Zielenergien zwischen 0,5 und 1 keV liegt dann das gesamte Strahlführungsrohr von der Anode bis zum Objektiv auf einem Potential, das betragsmäßig nur 0,5-1 keV kleiner als die Potentialdifferenz zwischen Kathode und Anode ist. Da die Isolation gegenüber der Umgebung entsprechend ausgelegt sein muß, ist diese Anordnung nur bei niedrigen Maximalenergien einsetzbar. Bei Zielenergien unter 0,2 keV wird die Emission mit abnehmender Zielenergie zunehmend instabil, da das Kathodenpotential dem Massepotential nahezu entspricht und dadurch jegliche Streufelder Einfluß auf die Emission nehmen. Für Zielenergien unter 0,2 keV ist diese Anordnung daher wenig geeignet.

Bei einer Anordnung nach der EP 0 180 723 B1 ist es vom LEO 1500 der Anmelderin bekannt, das Potential der Anode und des Strahlführungsrohres bis zur Abbremseinrichtung unabhängig von der Zielenergie konstant zu halten und zur Variation der Zielenergie das Kathodenpotential zu variieren. Dieses führt zu dem Nachteil, daß bei einer Änderung der Zielenergie sich stets auch die Energie der Teilchen innerhalb des Strahlführungsrohres ändert und demzufolge sämtliche Parameter innerhalb des Abbildungssystems, insbesondere die Stärke der Magnetlinsen, entsprechend angepaßt werden müssen. Dieses ist insbesondere bei niedrigen Energien und damit niedrigen Energien im Strahlführungsrohr kritisch, da bereits geringe Fehleinstellungen große Auswirkungen haben und deshalb der Niederenergiebereich, insbesondere der Bereich der Zielenergien unter 2 kV entsprechend feinstufig abgeglichen werden muß. Auch bei diesem Gerät entspricht das Kathodenpotential gegenüber dem Massepotential der Zielenergie, so daß auch bei dieser Anordnung die Emission bei Zielenergien unter 0,2 keV instabil wird.

Die folgende Erfindung soll eine Anordnung angeben, bei der auch bei niedrigsten Zielenergien, die auch unter 0,2 keV liegen können, ein stabiler und konstanter Betrieb gewährleistet werden kann, ohne daß das Objekt auf ein betragsmäßig gegenüber dem Massepotential hohes Potential gelegt werden muß. Zusätzlich sollte eine gute Detektierbarkeit der bei der Wechselwirkung der Korpuskeln mit dem Objekt entstehenden Sekundär- oder Rückstreuteilchen auch bei kurzen Abständen zwischen Objektiv und Objekt gewährleistet sein.

Dieses Ziel wird durch ein Korpuskularstrahlgerät mit den Merkmalen des Anspruches 1 gelöst. Vorteilhafte Ausgestaltungen der Erfindung ergeben sich aus den Merkmalen der abhängigen Ansprüche.

Das erfindungsgemäße Korpuskularstrahlgerät weist einen im wesentlichen bekannten Aufbau aus einer Teilchenquelle mit einer Kathode und einer Anode zur Emission und Beschleunigung der Teilchen, einem Strahlführungsrohr, mindestens einem Objektiv zur Fokussierung des Teilchenstrahls auf ein Objekt und einer Verzögerungseinrichtung auf. Die Anode und das Strahlführungsrohr liegen auf demselben, gegenüber dem Massepotential hohen Hochspannungspotential. Gleichzeitig liegt die letzte Elektrode der Verzögerungseinrichtung und die Probe ebenfalls auf einem gemeinsamen Potential, das zumindest bei den niedrigsten Zielenergien der Teilchen vom Massepotential abweicht und ein dem Anodenpotential entgegengesetztes Vorzeichen aufweist.

Die Erfindung verläßt damit die bisherigen Konstruktionswege, bei denen zumindest entweder das Stahlführungsrohr oder das Objekt auf Massepotential gehalten werden. Stattdessen werden die bekannten Lösungen derart miteinander kombiniert, daß die spezifischen Vorteile der bekannten Lösungen erreicht werden, ohne daß gleichzeitig die spezifischen Nachteile der einzelnen Lösungen inkauf genommen werden müssen. Denn beim Anlegen eines moderaten Hochspannungspotentials unter 5 kV an das Objekt treten noch keine großen Probleme bezüglich Isolation oder Objektschädigungen auf. Gleichzeitig wird jedoch erreicht, daß das Kathodenpotential gegenüber dem Massepotential auch bei niedrigsten Zielenergien auf einem Wert von ebenfalls 0,2-5 kV gehalten werden kann, bei dem die Emission stabil ist. Und bei hohen Zielenergien wird die Energieeinstellung durch betragsmäßiges Anheben des Kathodenpotentials erreicht, wobei das Objekt vorzugsweise auf Massepotential liegt.

Bei allen Zielenergien ist das Kathodenpotential größer als 0,2 kV, vorzugsweise größer als 0,5 kV. Das Vorzeichen des Kathodenpotentials ist in Abhängigkeit vom Vorzeichen der Korpuskelladungen so gewählt, daß die Korpuskeln auf Kathodenpotential gegenüber dem Massepotential eine höhere potentielle Energie aufweisen. Gleichzeitig beträgt das Anodenpotential betragsmäßig mehr als 5 kV und ist vorzeichenmäßig so gewählt, daß die Korpuskeln auf Anodenpotential gegenüber dem Massepotential eine geringere potentielle Energie aufweisen. Die aus der Kathode austretenden Korpuskeln werden dadurch auf eine Energie beschleunigt, die der Potentialdifferenz zwischen Kathode und Anode entspricht und mindestens 5-10 kV betragen sollte. Mit dieser Energie, bei der die chromatischen Fehler der Abbildungselemente sich noch in tolerierbaren Grenzen halten, durchlaufen die Korpuskeln das Strahlführungsrohr und werden nach Austritt aus dem Strahlführungsrohr auf die Zielenergie abgebremst. Die Einstellung der Zielenergie erfolgt dabei durch Einstellung des Potentials am Objekt und an der Verzögerungseinrichtung gegenüber dem Massepotential. Für Zielenergien zwischen Null und der Teilchenenergie auf Kathodenpotential bleibt damit die Energie innerhalb des Strahlführungsrohres konstant. Damit entfällt ein Feinabgleich der korpuskularoptischen Säule, was die Bedienung des Systems wesentlich vereinfacht und insbesondere bei zusätzlicher Verwendung von Korrekturelementen (z.B. von Multipolkorrektoren) zur Reduzierung der Aberrationen der Linsen einen wesentlichen Vorteil darstellt. Das für die Einstellung der Zielenergie erforderliche Probenpotential ist betragsmäßig maximal so groß wie das Kathodenpotential und beträgt maximal 5 kV, so daß noch keine Spannungsüberschläge, Isolationsprobleme und/oder Probenschädigungen beim Ein- und Ausschalten des Probenpotentials auftreten.

Die Einstellung höherer Zielenergien erfolgt beim erfindungsgemäßen Korpuskularstrahlgerät durch eine betragsmäßige Erhöhung des Kathodenpotentials. Das Anodenpotential bleibt konstant, damit stets eine gute Detektion von Sekundär- oder Rückstreuelektronen gewährleistet ist.

Beim Betrieb des Gerätes bei niedrigsten Zielenergien, insbesondere bei Zielenergien unter 0,5 keV liegt damit beim erfindungsgemäßen Korpuskularstrahlgerät die Probe und die Verzögerungseinrichtung auf einem Potential, das dasselbe Vorzeichen wie das Kathodenpotential aufweist. Das Anodenpotential weist dagegen ein entgegengesetztes Vorzeichen auf.

Für die Einstellung der unterschiedlichen Potentiale sind beim erfindungsgemäßen Korpuskularstrahlgerät drei regelbare Hochspannungsquellen jeweils für die Potentiale der Verzögerungseinrichtung, der Anode und der Kathode vorgesehen. Die Einstellung der optimalen Potentiale kann durch eine Steuerung in Abhängigkeit von den Werten für die Zielenergie und das maximal zulässige Probenpotential als vom Benutzer einzugebende Parameter erfolgen.

Bei einem vorteilhaften Ausführungsbeispiel weist das Strahlführungsrohr in einem Bereich zwischen dem Korpuskularstrahlerzeuger und dem Objektiv einen aufgeweiteten Bereich auf, in dem ein auf dem Potential des Strahlführungsrohres liegender Detektor zum Nachweis der von dem Objekt ausgehenden Sekundärelektronen angeordnet ist. Die aus dem Objekt austretenden Sekundärelektronen oder Rückstreuelektronen werden in rückwärtiger Richtung des Primärstrahls durch die Verzögerungseinrichtung auf die Differenz zwischen dem Potential der Probe und dem Potential des Strahlführungsrohres beschleunigt und haben genügend Energie um gut nachweisbar zu sein.

Das erfindungsgemäße Korpuskularstrahlgerät kann nur mit einem Objektiv als einzigem abbildenden Element oder als mindestens zweilinsiges System aus Objektiv und Kondensor ausgebildet sein. Ein zweilinsiges Abbildungssystem aus Kondensor und Objektiv findet vorteilhaft in Kombination mit einer Quelle Anwendung, aus der die Korpuskeln relativ ungerichtet austreten, da die nutzbare Apertur der aus der Kathode austretenden Korpuskeln bei zweistufigen Systemen größer als bei einstufigen Systemen ist. Bei schwacher Erregung des Kondensors wird die objektivseitige Apertur des Teilchenstrahls verringert und kann damit optimal an die Erfordernisse angepaßt werden. Die bei zweistufigen Abbildungssystemen mit einer Zwischenabbildung der Quelle zwischen den Teilchen auftretenden stochastischen Wechselwirkungen führen jedoch zu einer Energieverbreitung und damit zu größeren energieabhängigen Abbildungsfehlern, so daß bei Quellen, die stark gerichtet emittieren, ein nur aus einem Objektiv bestehendes einstufiges Abbildungssystem vorzuziehen ist.

Die Verzögerungseinrichtung kann beim erfindungsgemäßen Korpuskularstrahlgerät durch das hintere Ende des Strahlführungsrohres und eine oder mehrere weitere Elektroden ausgebildet sein. Dazu ist das hintere Ende des Strahlführungsrohres vorteilhaft als Rohrelektrode ausgebildet. Die weitere Elektrode der Verzögerungseinrichtung ist vorzugsweise an einem Isolierkörper des Objektivs aufgenommen.

Das Objektiv kann grundsätzlich als magnetisches Objektiv oder als elektrostatische Einzellinse ausgebildet sein.

Nachfolgend werden Einzelheiten der Erfindung am Beispiel von Rasterelektronenmikroskopen anhand der in den Figuren dargestellten Ausführungsbeispiele näher erläutert. Im einzelnen zeigen:
- Figur 1: eine Prinzipskizze eines ersten Ausführungsbeispiels eines erfindungsgemäßen Korpuskularstrahlgerätes im Schnitt;
- Figur 2: eine Prinzipskizze eines zweiten Ausführungsbeispiels des erfindungsgemäßen Korpuskularstrahlgerätes im Schnitt; und
- Figur 3: eine Detaildarstellung des unteren Objektivteils bei einem Korpuskularstrahlgerät gemäß der vorliegenden Erfindung im Schnitt.

Der Korpuskularstrahlerzeuger beim erfindungsgemäßen Korpuskularstrahlgerät besteht aus einer die Korpuskeln emittierenden Kathode (1), einer Extraktionselektrode (2) und einer Anode (4). Ist das erfindungsgemäße Korpuskularstrahlgerät als Rasterelektronenmikroskop ausgebildet, ist die Kathode (1) vorzugsweise ein thermischer Feldemitter. Je nach Ausbildung der Kathode (1) liegt die Extraktionselektrode (2) auf einem Potential von 2-5 kV gegenüber der Kathode (1), so daß die Korpuskeln von der Extraktionselektrode (2) aus der Kathode (1) herausgesaugt werden. Für die Erzeugung des Kathodenpotentials U_{K} ist eine erste regelbare Hochspannungsquelle (14) und für die Erzeugung der festen Potentialdifferenz zwischen Kathode (1) und Extraktionselektrode (2) ist eine feste Spannungsquelle (3) vorgesehen.

Die Anode (4) bildet gleichzeitig das quellenseitige Ende des Strahlführungsrohres (5). Dieses Strahlführungsrohr (5) aus elektrisch leitendem Material ist durch eine Bohrung durch die Polschuhe (6) einer als Objektiv wirkenden Magnetlinse geführt und ist am objektseitigen Ende (8) als Rohrlinse verdickt ausgebildet. Dieses verdickte objektseitige Ende des Strahlführungsrohres (5) endet erst hinter dem Polschuhspalt der Magnetlinse, deren Spulen mit (7) bezeichnet sind. Dem Strahlführungsrohr nachgeordnet ist eine Einzelelektrode (9), die gemeinsam mit der Rohrelektrode (8) des Strahlführungsrohres (5) eine elektrostatische Verzögerungseinrichtung bildet. Die Rohrelektrode (8) liegt gemeinsam mit dem gesamten Strahlführungsrohr (5) auf dem Anodenpotential U_{A}, das durch eine zweite regelbare Hochspannungsquelle (13) erzeugt wird und die Einzelelektrode (9) und der Objekttisch (10) liegen auf einem gemeinsamen Potential Up, das von einer dritten regelbaren Hochspannungsquelle erzeugt wird. Die Rohrelektrode (8) und die Einzelelektrode (9) wirken gleichzeitig als elektrostatische Linse (Immersionslinse), durch die der Korpuskelstrahl zusätzlich zur Wirkung des Objektivs auf das Objekt fokussiert wird.

Beim Betrieb des Korpuskularstrahlgerätes werden die aus der Kathode austretenden Korpuskeln bis zur Anode um eine der Potentialdifferenz zwischen Kathode (1) und Anode (4) entsprechende Energie beschleunigt und durchlaufen nachfolgend das Strahlführungsrohr (5) mit dieser konstanten Energie. Nach Austritt aus dem Strahlführungsrohr zwischen der Rohrelektrode (8) und der Einzelelektrode (9) werden die Korpuskeln dann auf eine der Potentialdifferenz zwischen dem Kathodenpotential U_{K} und dem Probenpotential Up entsprechende Zielenergie verzögert. Die Einstellung dieser Zielenergie erfolgt bei niedrigen Zielenergien über eine Änderung des Probenpotentials Up bei jeweils festem Anodenpotential U_{A} und Kathodenpotential U_{K}. Niedrige Energien sind dabei Energien, die betragsmäßig kleiner als die Korpuskelenergie auf Kathodenpotential ist. Bei höheren Zielenergien ist das Probenpotential Up Null und die Konstanthaltung der Teilchenenergie innerhalb des Strahlführungsrohres erfolgt durch aufeinander abgestimmte Änderung des Kathodenpotentials U_{K} und des Anodenpotentials U_{A}. Beispielhafte Potentialkombinationen für Sollenergien innerhalb des Strahlführungsrohres von 10 bzw. 15 keV im Falle von Elektronen sind in den Tabellen 1 und 2 angegeben. Für beliebige Zielenergien zwischen den angegebenen Werten lassen sich die zugehörigen anderen Potentialwerte leicht ergänzen. Für Zielenergien zwischen 0 keV und der Sollenergie im Strahlführungsrohr kann beim erfindungsgemäßen Korpuskularstrahlgerät die Energie U_{S} im Strahlführungsrohr konstant gehalten werden. Für die Einstellung der geeigneten Potentialkombinationen kann eine Steuerung (15) vorgesehen sein, die die geeigneten Potentialkombinationen als Funktion der Zielenergie, der Sollenergie im Strahlführungsrohr und dem maximal zulässigen Probenpotential Up als vom Benutzer vorgebbare Parameter auswählt.

**Tabelle 1**

| Zielenergie/keV | U_{K}/kV | U_{A}/kV | U_{P}/kV | U_{S}/keV |
|---|---|---|---|---|
| 0 | -2 | 8 | -2 | 10 |
| 0,5 | -2 | 8 | -1,5 | 10 |
| 1 | -2 | 8 | -1 | 10 |
| 2 | -2 | 8 | 0 | 10 |
| 3 | -3 | 8 | 0 | 11 |
| 5 | -5 | 8 | 0 | 13 |
| 10 | -10 | 8 | 0 | 18 |
| 15 | 15 | 8 | 0 | 23 |
| 20 | 20 | 8 | 0 | 28 |
| 30 | 30 | 8 | 0 | 38 |

**Tabelle 2**

| Zielenergie/keV | U_{K}/kV | U_{A}/kV | U_{P}/kV | U_{S}/keV |
|---|---|---|---|---|
| 0 | -2 | 13 | -2 | 15 |
| 0,5 | -2 | 13 | -1,5 | 15 |
| 1 | -2 | 13 | -1 | 15 |
| 2. | -2 | 13 | 0 | 15 |
| 3 | -3 | 13 | 0 | 16 |
| 5 | -5 | 13 | 0 | 18 |
| 10 | -10 | 13 | 0 | 23 |
| 15 | -15 | 13 | 0 | 28 |
| 20 | -20 | 13 | 0 | 33 |
| 30 | -30 | 13 | 0 | 43 |

Für die Abrasterung eines größeren Objektbereiches ist ein Ablenksystem (11) vorgesehen, das auf der Höhe des Polschuhspaltes außerhalb des Strahlführungsrohres angeordnet ist. Durch die Anordnung des Ablenksystems (11) auf der Höhe des Polschuhspaltes ist gewährleistet, daß die Ablenkung für die Abrasterung des Objektes in der Hauptebene des Objektivs erfolgt.

Im quellenseitigen Bereich zwischen dem Teilchenstrahlerzeuger und dem Objektiv oder im quellenseitigen Bereich des Objektives ist das Strahlführungsrohr erweitert. In diesem erweiterten Bereich ist ein konzentrisch zur optischen Achse angeordneter ringförmiger Detektor (16) für Sekundär- oder Rückstreuelektronen angeordnet. Aus dem Objekt austretende Elektronen werden in inverser Richtung zum Primärstrahl durch das Verzögerungsfeld zwischen der Einzelelektrode (9) und der Rohrelektrode (8) auf das Differenzpotential U_{A} - U_{K} beschleunigt und haben somit hinreichend Energie, um mittels eines Halbleiterdetektors oder Szintillationsdetektors nachweisbar zu sein. Die Emission der Elektronen aus dem Objekt muß dabei nicht zwingend durch einen Primärelektronenstrahl stimuliert sein, es ist vielmehr auch möglich, daß die Stimulation mittels UV-Licht oder Gammastrahlung erfolgt, wozu dann das Gerät zusätzliche UV-Lichtquellen und/oder Gammastrahlungsquellen aufweist.

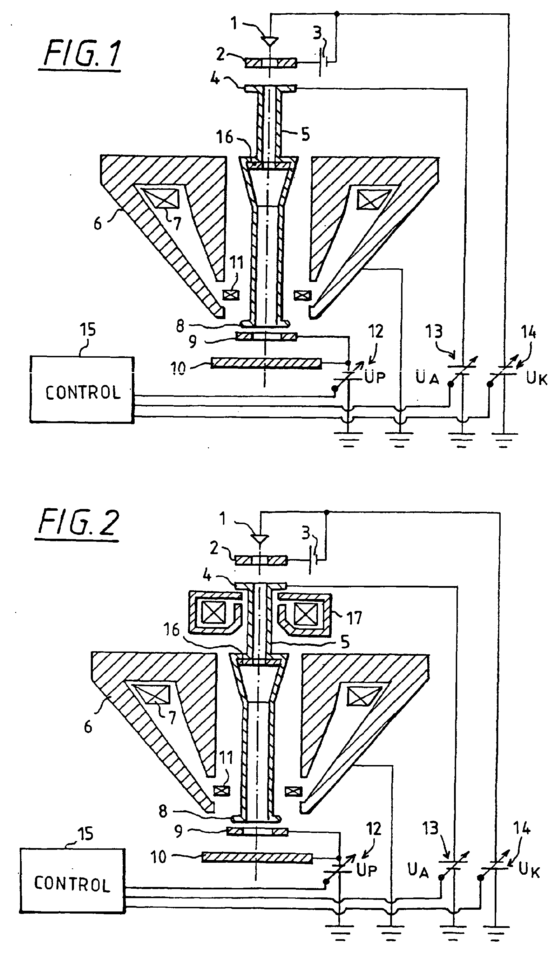

Bei dem Ausführungsbeispiel in Figur 2 sind die zum Ausführungsbeispiel der Figur 1 identischen Komponenten mit identischen Bezugszeichen versehen. Der einzige Unterschied zwischen beiden Ausführungsbeispielen ist, daß zwischen der Anode (4) und dem Objektiv (6, 7) zusätzlich ein Kondensor (17) als zusätzliche Abbildungsstufe vorgesehen ist. Der Kondensor (17) erzeugt ein reelles Zwischenbild der emittierenden Fläche der Kathode (1), welches nachfolgend vom Objektiv (6, 7) auf das Objekt abgebildet wird. Bei einem solchen zweistufigen Abbildungssystem ist gegenüber dem einstufigen Abbildungssystem in Figur 1 die Ausbeute der von der Kathode emittierten Teilchen, die auf das Objekt fokussiert werden, etwas größer. Dafür treten im Zwischenbild der Kathode (1), also im sogenannten Crossover, stochastische Wechselwirkungen zwischen den Teilchen auf, wodurch die chromatischen Aberrationen des gesamten Abbildungssystems vergrößert werden.

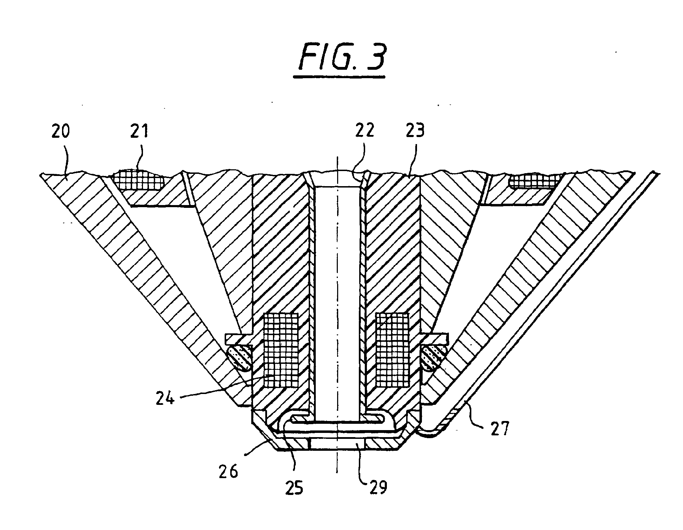

In der Detaildarstellung des objektseitigen Bereiches des Objektivs in Figur 3 sind die Polschuhe des Objektivs mit (20) und die Objektivspulen mit (21) bezeichnet. In einer Bohrung des Objektivpolschuhs (20) ist das Strahlführungsrohr (22) über einen das Strahlführungsrohr ringförmig umgebenden Isolator (23) aufgenommen. Auf der Höhe des Polschuhspaltes des Polschuhs (20) ist das Ablenksystem (24) angeordnet. Das objektseitige Ende des Strahlführungsrohres (22) weist wiederum eine ringförmige Verbreiterung auf, so daß das objektseitige Ende des Strahlführungsrohres (22) als Rohrelektrode wirkt. Weiterhin am Isolator (23) ist die zweite Elektrode (26) aufgenommen, die gemeinsam mit der Rohrelektrode (25) des Strahlführungsrohres (22) die Abbremseinrichtung bildet. Dabei ist das Strahlführungsrohr (22) soweit fortgesetzt, daß die Rohrelektrode (25) - in Richtung des Primärelektronenstrahls - hinter dem Polschuhspalt in einem Bereich angeordnet ist, in dem das aus dem Polschuhspalt austretende Magnetfeld nahezu vollständig abgeklungen ist. Die Abbremsung der Teilchen auf die Zielenergie erfolgt damit unmittelbar vor dem Objekt, wodurch Störeinflüsse durch externe elektrische oder magnetische Felder reduziert werden.

Die Abbremselektrode (26) ist als zentrisch abgeflachter konischer Ring mit einer Mittenbohrung (29) ausgebildet. Die Mittenbohrung (29) ist zur Bohrung des Polschuhs (20) und zum Strahlführungsrohr (22) zentriert angeordnet. Durch die konische Ausbildung der Elektrode (26) werden Kollisionen zwischen der Elektrode (26) und dem Objekt bei einer Objektkippung vermieden.

Die Potentialversorgung der Abbremselektrode (26) erfolgt über eine Zuführung (27) an der Außenfläche des Objektiv-Polschuhs (20).

An dieser Stelle sei angemerkt, daß die Abbremsung der Korpuskeln nicht zwingend hinter dem Objektiv erfolgen muß, auch wenn dieses bevorzugt wird, weil dadurch die Korpuskeln möglichst lange auf hoher kinetischer Energie gehalten werden.

Es ist jedoch auch eine Anordnung der Abbremseinrichtung innerhalb des Objektivs wie in der eingangs zitierten EP 0 180 723 B1 denkbar.

Anhand der in den Figuren dargestellten Ausführungsbeispiele wurde die Erfindung für den Fall erläutert, daß die Korpuskeln Elektronen sind. Bei Anwendung der Erfindung auf positiv geladene Teilchen braucht lediglich die Polung von Kathodenpotential, Anodenpotential und Probenpotential invertiert zu werden, d.h. ein positives Potential wird durch ein negatives und ein negatives durch ein positives Potential ersetzt.

Weiterhin muß das Objektiv nicht zwingend als Magnetlinse ausgebildet zu sein. Es ist auch denkbar und insbesondere bei Verwendung schwerer Korpuskeln wie Ionen vorteilhaft, für die Fokussierung der Korpuskeln eine elektrostatische Einzellinse einzusetzen. Eine solche elektrostatische Einzellinse kann in bekannter Weise aus drei aufeinander folgenden Elektroden aufgebaut sein, von denen die beiden aüßeren Elektroden auf dem Potential des Strahlführungsrohres liegen; die mittlere Elektrode liegt dann auf einem Potential, das bezüglich der Polarität dem Kathodenpotential entspricht, jedoch betragsmäßig etwas kleiner ist. Zur Aufnahme einer solchen Einzellinse kann das Strahlführungsrohr einen quaderförmigen aufgeweiteten Bereich aufweisen, in dem die Mittelelektrode angeordnet ist. Die beiden Randelektroden werden dann durch die senkrecht zur Rohrachse stehenden Quaderflächen gebildet. Eine solche Einzellinse führt im Gegensatz zur elektrostatischen Immersionslinse zu keiner Änderung der Teilchenenergie.

## Patentansprüche

1. Korpuskularstrahlgerät mit einem Korpuskularstrahlerzeuger, welcher eine Kathode (1), eine Anode (4) und eine der Anode zugeordnete zweite Hochspannungsquelle (13) aufweist, die ein Anodenpotential zur Beschleunigung der aus der Kathode (1) austretenden Korpuskeln auf das Anodenpotential erzeugt, einem Strahlführungsrohr (5), einem Objektiv (6, 7) zur Fokussierung des Korpuskularstrahls auf ein Objekt, einer Verzögerungseinrichtung (8, 9), einer der Verzögerungseinrichtung zugeordneten dritten Hochspannungsquelle (12) und einem Objekttisch (10), wobei die Anode (4) und das Strahlführungsrohr (5) so ausgebildet sind, dass sie auf demselben, gegenüber dem Massepotential hohen Hochspannungspotential der zweiten Hochspannungsquelle (13) liegen und wobei die dritte Hochspannungsquelle (12) mit der Verzögerungseinrichtung(8, 9) und dem Objekttisch (10) verbunden ist, so dass die verzögerungseinrichtung (8, 9) und das Objekt (10) auf demselben Potential liegen, und die dritte Hochspannungsquelle bei niedrigen zielenergien ein Potential erzeugt, das vom Massepotential abweicht und dem Anodenpotential entgegengesetzt ist.

2. Korpuskularstrahlgerät nach Anspruch 1, wobei eine erste Hochspannungsquelle (14) zur Erzeugung eines Kathodenpotentials (UK) vorhanden ist, das betragsmäßig stets größer als 0,2 kV ist und wobei das Vorzeichen des Kathodenpotentials in Abhängigkeit vom Vorzeichen der Ladungen der Korpuskeln so gewählt ist, dass die Korpuskeln gegenüber dem Massepotential eine höhere potentielle Energie aufweisen und wobei das Anodenpotential (UA) vorzeichenmäßig so gewählt ist, dass die Korpuskeln auf dem Anodenpotential gegenüber dem Massepotential eine geringere potentielle Energie aufweisen.

3. Korpuskularstrahlgerät nach Anspruch 1 oder 2, wobei das Potential der dritten Hochspannungsquelle (12) zur Änderung der Zielenergie der Korpuskeln auf dem Objekt gegenüber dem Massepotential variierbar ist.

4. Korpuskularstrahlgerät nach einem der Ansprüche 1-3, wobei der Objekttisch und die Verzögerungseinrichtung (8, 9) bei niedrigen zielenergien der Korpuskeln auf einem dem Kathodenpotential (UK) vorzeichenmäßig gleichgerichteten Potential gegenüber dem Massepotential liegen.

5. Korpuskularstrahlgerät nach einem der Ansprüche 2-4 wobei das Potential der dritten Hochspannungsquelle (12)zwischen dem Wert des Massepotentials und des Kathodenpotentials (UK)als Grenzwerte einstellbar ist.

6. Korpuskularstrahlgerät nach einem der Ansprüche 1-5, wobei das Strahlführungsrohr (5) in einem Bereich zwischen Strahlerzeuger und der Objektivlinse (6, 7) aufgeweitet ist und einen auf dem Potential des Strahlführungsrohres (5) liegenden Detektor (16) zum Nachweis von Sekundär- oder Rückstreuelektronen aufweist.

7. Korpuskularstrahlgerät nach einem der Ansprüche 1-6, wobei die Verzögerungseinrichtung aus einer Einzelelektrode (9) besteht, die mit dem objektseitigen Ende (8) Strahlführungsrohres (5) zusammenwirkt.

8. Korpuskularstrahlgerät nach Anspruch 7 wobei das Strahlführungsrohr (5) am objektseitigen Ende als Rohrelektrode (8) ausgebildet ist und wobei die Einzelelektrode (9) an einem Isolierkörper (23) am Objektiv (20, 21) aufgenommen ist.

## Claims

1. Corpuscular beam apparatus comprising a corpuscular beam generator having a cathode (1), an anode (4) and a second high-voltage source (13), which is assigned to the anode and which generates an anode potential for accelerating the corpuscles emerging from the cathode (1) to the anode potential, a beam guiding tube (5), an objective (6, 7) for focusing the corpuscular beam onto an object, a retardation device (8, 9), a third high-voltage source (12), which is assigned to the retardation device, and an object stage (10), wherein the anode (4) and the beam guiding tube (5) are embodied such that they are at the same high-voltage potential of the second high-voltage source (13) the said potential being high with respect to the earth potential, and wherein the third high-voltage source (12) is connected to the retardation device (8, 9) and the object stage (10), such that the retardation device (8, 9) and the object (10) are at the same potential, and the third high-voltage source, in the case of low target energies, generates a potential that deviates from the earth potential and is opposite to the anode potential.

2. Corpuscular beam apparatus according to Claim 1, wherein a first high-voltage source (14) for generating a cathode potential (UK) is present, the magnitude of said potential always being greater than 0.2 kV, and wherein the sign of the cathode potential is chosen in a manner dependent on the sign of the charges of the corpuscles such that the corpuscles have a higher potential energy with respect to the earth potential, and wherein the sign of the anode potential (UA) is chosen such that the corpuscles at the anode potential have a lower potential energy with respect to the earth potential.

3. Corpuscular beam apparatus according to Claim 1 or 2, wherein the potential of the third high-voltage source (12) can be varied for changing the target energy of the corpuscles on the object with respect to the earth potential.

4. Corpuscular beam apparatus according to any of Claims 1-3, wherein the object stage and the retardation device (8, 9), in the case of low target energies of the corpuscles, are at a potential having an identical sign to the cathode potential (UK) with respect to the earth potential.

5. Corpuscular beam apparatus according to any of Claims 2-4, wherein the potential of the third high-voltage source (12) can be set between the value of the earth potential and the cathode potential (UK) as limit values.

6. Corpuscular beam apparatus according to any of Claims 1-5, wherein the beam guiding tube (5) is widened in a region between the beam generator and the objective lens (6, 7) and has a detector (16) for detecting secondary or backscattering electrons, said detector being at the potential of the beam guiding tube (5).

7. Corpuscular beam apparatus according to any of Claims 1-6, wherein the retardation device comprises an individual electrode (9), which interacts with the object-side end (8) of the beam guiding tube (5).

8. Corpuscular beam apparatus according to Claim 7, wherein the beam guiding tube (5) is embodied as tube electrode (8) at the object-side end, and wherein the individual electrode (9) is accommodated at an insulating body (23) at the objective (20, 21).

## Revendications

1. Appareil à rayonnement corpusculaire comprenant un générateur de rayon corpusculaire qui présente une cathode (1), une anode (4) et une deuxième source de haute tension (13) associée à l'anode, laquelle génère un potentiel d'anode pour accélérer au potentiel d'anode les corpuscules qui sortent de la cathode (1), un tube de focalisation du rayon (5), un objectif (6, 7) pour focaliser le rayon corpusculaire sur un objet, un dispositif de retard (8, 9), une troisième source de haute tension (12) associée au dispositif de retard et un plateau porte-objet (10), l'anode (4) et le tube de focalisation du rayon (5) étant configurés de telle sorte qu'ils se trouvent au même potentiel de haute tension de la deuxième source de haute tension (13) par rapport au potentiel de masse et la troisième source de haute tension (12) étant reliée avec le dispositif de retard (8, 9) et le plateau porte-objet (10) de telle sorte que le dispositif de retard (8, 9) et l'objet (10) se trouvent au même potentiel, et la troisième source de haute tension, avec une faible énergie de cible, génère un potentiel qui est différent du potentiel de masse et à l'opposé du potentiel d'anode.

2. Appareil à rayonnement corpusculaire selon la revendication 1, une première source de haute tension (14) étant présente pour générer un potentiel de cathode (UK) dont la valeur est toujours supérieure à 0,2 kV et le signal du potentiel de cathode étant choisi en fonction du signal des charges des corpuscules de telle sorte que les corpuscules présentent une énergie potentielle supérieure par rapport au potentiel de masse et le signe du potentiel d'anode (UA) étant choisi de telle sorte que les corpuscules au potentiel d'anode présentent une énergie potentielle plus faible par rapport au potentiel de masse.

3. Appareil à rayonnement corpusculaire selon la revendication 1 ou 2, le potentiel de la troisième source de haute tension (12) pouvant varier par rapport au potentiel de masse pour modifier l'énergie de cible des corpuscules sur l'objet.

4. Appareil à rayonnement corpusculaire selon l'une des revendications 1 à 3, le plateau porte-objet et le dispositif de retard (8, 9), en présence d'une faible énergie de cible des corpuscules, se trouvant par rapport au potentiel de masse à un potentiel ayant le même signe que le potentiel de cathode (UK).

5. Appareil à rayonnement corpusculaire selon l'une des revendications 2 à 4, le potentiel de la troisième source de haute tension (12) étant réglable entre la valeur du potentiel de masse et le potentiel de cathode (UK) servant de valeurs limites.

6. Appareil à rayonnement corpusculaire selon l'une des revendications 1 à 5, le tube de focalisation du rayon (5) étant élargi dans une zone entre le générateur de rayon et la lentille d'objectif (6, 7) et présentant un détecteur (16) qui se trouve au potentiel du tube de focalisation du rayon (5) pour détecter les électrons secondaires ou rétrodiffusés.

7. Appareil à rayonnement corpusculaire selon l'une des revendications 1 à 6, le dispositif de retard se composant d'une électronique unique (9) qui interagit avec l'extrémité côté objet (8) du tube de focalisation du rayon (5).

8. Appareil à rayonnement corpusculaire selon la revendication 7, l'extrémité côté objet du tube de focalisation du rayon (5) étant réalisée sous la forme d'une électrode tubulaire (8) et l'électrode unique (9) étant logée sur un corps isolant (23) sur l'objectif (20, 21).
